# NEUE EUROPÄISCHE PATENTSCHRIFT

(11) **EP 2 736 657 B2**
(45) Veröffentlichungstag und Bekanntmachung des Hinweises auf die Entscheidung über den Einspruch: **29.09.2021**
(45) Hinweis auf die Patenterteilung: 16.09.2015
(21) Anmeldenummer: 12740088.5
(22) Anmeldetag: 05.07.2012
(51) Int. Cl.: B05C 5/02

(54) **DOSIERSYSTEM UND DOSIERVERFAHREN**
DOSING SYSTEM AND DOSING METHOD
SYSTÈME DE DOSAGE ET PROCÉDÉ DE DOSAGE

(30) Priorität: 29.07.2011 DE 102011108799
(43) Veröffentlichungstag der Anmeldung: 04.06.2014
(73) Patentinhaber: Vermes Microdispensing GmbH, 83624 Otterfing (DE)
(72) Erfinder: FLIESS, Mario, 81825 München (DE); STAEDTLER, Jürgen, 83620 Feldkirchen-Westerham (DE)
(74) Vertreter: Beckord & Niedlich Patentanwälte PartG mbB
(86) Internationale Anmeldenummer: PCT/EP2012/063078
(87) Internationale Veröffentlichungsnummer: WO 2013/017368

(56) Entgegenhaltungen:
- EP-A1- 1 652 588
- EP-A1- 2 143 503
- EP-A2- 1 414 080
- EP-A2- 1 588 777
- WO-A1-2011/071888
- DE-A1- 2 717 539
- DE-C2- 3 108 793
- JP-A- 2004 225 666
- US-A- 5 730 359
- US-A1- 2005 236 438
- US-B2- 8 490 575
- Wikipedia: "Piezoelektrizität", , 7 July 2010 (2010-07-07),

## Beschreibung

Die vorliegende Erfindung betrifft ein Dosiersystem für einen flüssigen bis zähflüssigen Dosierstoff. Sie betrifft weiterhin ein Verfahren zum Dosieren eines flüssigen bis zähflüssigen Dosierstoffs. Ein Dosiersystem bzw. ein Verfahren zum Dosieren eines flüssigen bis zähflüssigen Dosierstoffs mittels eines Dosiersystems gemäß dem Oberbegriff des Anspruchs 1 bzw. des Anspruchs 11 ist aus der EP 2 143 503 A1 bekannt.

Die Abgabe (insbesondere einer möglichst genau bemessenen Menge), das heißt das Dosieren, von flüssigen bis zähflüssigen Dosierstoffen, beispielsweise von Klebstoffen, Farben, Drucklacken, in einem Bindersystem gebundenen leitenden Substanzen wie Lötpasten, Convertermaterialien für LEDs uvm. dient der gezielten Aufbringung solcher Dosierstoffe, beispielsweise auf Zieloberflächen. Beispielsweise werden elektronische Leiterplatinen gezielt und punktgenau mit leitenden Substanzen versehen, was früher notwendige aufwändige Prozesse, etwa Rakelprozesse auf Basis einer Maskierung, ersetzt. Eine besondere Herausforderung besteht dabei darin, die Dosierstoffe hochgenau, das heißt zum richtigen Zeitpunkt, am richtigen Ort und in einer genau dosierten Menge auf die Zieloberfläche zu befördern. Dies kann beispielsweise dadurch erfolgen, dass eine tröpfchenweise Abgabe über die Düse eines Dosiersystems erfolgt, wobei die Größe und/oder die Menge der Tröpfchen durch die Wirkung der Düse möglichst genau vorherbestimmt werden. Alternativ kann der Dosierstoff in einem Strahl aufgespritzt oder in einem Nebel aufgesprüht werden.

Die Herausforderung einer hochgenauen Dosierung wird insbesondere dann nochmals deutlich größer, wenn es sich bei dem Dosierstoff nicht um eine leichtflüssige Substanz handelt, etwa mit einer Konsistenz ähnlich der von Wasser, sondern um ein relativ zähflüssiges Medium. Beispiele hierfür sind hochangereicherte Klebstoffe, stark pigmentangereicherte Farben bzw. Lacke mit einem hohen Pigmentanteil uvm. Besonders bei solchen Stoffen und/oder in Situationen, wo Dosierstoffe aufgetragen werden sollen, deren Dosierung ganz besonders fein eingestellt werden muss, ist es entscheidend, dass die Düse genau zu einem gewünschten Zeitpunkt schließt. Hierdurch wird ein gezielter Tropfenabriss der durch die Düse ausgestoßenen Tropfen erreicht und damit eine möglichst exakte Dosierung durch möglichst kleine Tropfen ermöglicht.

In der DE 27 17 539 A1 werden Vorrichtungen zum Dosieren von flüssigen Einkomponentenklebern beschrieben. In diesen Vorrichtungen werden jeweils mit Druckluft beaufschlagte Nadelventile verwendet.

Weiterhin wird eine Klebstoff-Auftragsvorrichtung in der DE 31 08 793 C2 beschrieben, bei der der Klebstoff nach unten aus einer Düsenöffnung tropft, wobei über einen Ringspalt außerhalb der Düse zur Unterstützung Druckluft ausgegeben wird, die den Klebstoff mitnimmt. Die Düsenöffnung ist über eine an einem Kolben befestigte, und darüber in der Lage verschiebbare Düsennadel verschließbar.

Das US Patent US 7 694 855 B2 beschreibt ein Dosiersystem mit einem pneumatischen Aktorsystem, dass über einen Hebel auf einen Stößel wirkt, der eine Austrittsöffnung einer Düse öffnet und verschließt.

Derartige Systeme gelangen bei hochpräzisen Feinanwendungen, speziell im Bereich der Mikrodosierung insbesondere im Bereich der oben erwähnten Dosierstoffe an ihre technischen Grenzen, welche speziell durch die zu langsame Mechanik bedingt sind.

Aufgabe der vorliegenden Erfindung ist es daher, eine Möglichkeit bereitzustellen, wie die Dosierung von Dosierstoffen mittels eines Dosiersystems mit einer Düse optimiert werden kann. Dabei wird insbesondere ein Augenmerk darauf gelegt, dass das Dosiersystem und die Düse effektiver und/oder genauer arbeiten können als dies bisher der Fall ist. Dabei ist es bevorzugt, dass es ermöglicht wird, kleinere Tropfengrößen als bisher zu realisieren.

Diese Aufgabe wird durch ein Dosiersystem gemäß Anspruch 1 und durch ein Verfahren gemäß Anspruch 11 gelöst.

Demgemäß umfasst ein Dosiersystem der eingangs genannten Art ein Aktorsystem, das mindestens ein Betätigungselement umfasst, und eine Düse mit einer Austrittsöffnung, wobei das Betätigungselement bei einer Bewegung in einer Verschlussrichtung zuerst in einer ersten Teilbewegung so bewegt wird, dass es von dem Verschlusselement an einem bestimmungsgemäßen Anschlagort getrennt ist, und dann auf das Verschlusselement am Anschlagort auftrifft und einen Impuls auf das Verschlusselement ausübt.

Das Aktorsystem ist hierzu bevorzugt in einem eigens dafür vorgesehenen Aktorbereich angeordnet, der vom Bereich der Düse räumlich möglichst abgetrennt ist. Als Aktorsystem wird ein solches System definiert, dass mindestens einen (bevorzugt selbsttätigen) Aktor umfasst. Das Betätigungselement umfasst einen Hebel. Das Betätigungselement betätigt mit anderen Worten das Verschlusselement direkt über einen temporären Kontakt am Anschlagort.

Als Anschlagort wird jener eigens dafür vorgesehene Kontaktbereich zwischen dem Betätigungselement und dem Verschlusselement bezeichnet, der zu einer gezielten Kraft- bzw. Bewegungsübertragung, d.h. zur Impulsübertragung zwischen dem Betätigungselement und dem Verschlusselement bestimmungsgemäß vorgesehen ist. Als Anschlagort kann daher ein einzelner punktförmiger Kontaktbereich dienen, ebenso ein linienförmiger oder ein flächiger Kontaktbereich.

Als Verschlusselement wird ein einstückiges oder mehrstückiges mechanisches Element definiert, das bevorzugt eine längliche Form, beispielsweise eine zylindrische Form, aufweist, also beispielsweise ein Stößel, zum Beispiel hergestellt unter Verwendung von Silizium. Es kann jedoch auch ein rundes oder ovales Verschlusselement sein, das einen Verschlusskanal und/oder die Austrittsöffnung in einer (Verschluss-)Stellung verschließt. Ein Verschlusskanal ist in diesem Zusammenhang ein Hohlkörper, bevorzugt ein zylindrischer Hohlkörper, der an seiner Innenseite einen Hohlraum definiert, d.h. einschließt, innerhalb dessen das Verschlusselement mindestens bereichsweise so angeordnet ist, dass das Verschlusselement den Hohlraum verschließt.

Das Verschlusselement kann, beispielsweise betätigt durch das Aktorsystem, in einer Öffnungs- bzw. einer Verschlussrichtung bewegt werden. Es ergibt sich also eine Hin- und Herbewegung des Verschlusselements, wofür es in diesen beiden Bewegungsrichtungen bewegbar angeordnet und gelagert ist.

Erfindungsgemäß wird ein solches System nun so ausgebildet, dass die Bewegung des Betätigungselements in mindestens zwei Teilbewegungen unterteilt werden kann: In einer ersten Teilbewegung wird das Betätigungselement unabhängig vom Verschlusselement, bevorzugt kontaktfrei vom Verschlusselement, bewegt. Während dieser ersten Teilbewegung ist das Betätigungselement an einem bestimmungsgemäßen Anschlagort vom Verschlusselement (noch) getrennt. Das Betätigungselement wird dann (zum Ende dieser ersten Teilbewegung) mit dem Verschlusselement am Anschlagort in Kontakt gebracht und überträgt dabei einen Impuls. Das Betätigungselement und das Verschlusselement vollziehen dann gemeinsam eine zweite Teilbewegung weiter in Verschlussrichtung, wobei sie auch während dieser zweiten Teilbewegung nicht zwangsläufig in Kontakt am Anschlagort sein müssen. Es kann also lediglich eine Impulsübertragung auf das Verschlusselement erfolgen, die dazu führt, dass das Verschlusselement schneller weiter in Verschlussrichtung verfährt als das Betätigungselement. Es können sich jedoch auch beide Elemente in der zweiten Teilbewegung über einen gewissen Zeitraum gemeinsam in beiderseitigem Kontakt bewegen, bevorzugt bis in die bestimmungsgemäße Endposition des Verschlusselements, in der das Verschlusselement die Düse des Dosiersystems vollständig verschließt. Diese Endposition ist insbesondere dann erreicht, wenn das Verschlusselement so auf einer Austrittsöffnung der Düse positioniert ist, dass diese vom Verschlusselement verschlossen ist.

Eine solche temporäre An- und Abkopplung, das heißt Verbindung und Trennung von Betätigungselement und Verschlusselement bewirkt, dass das Aktorsystem, insbesondere das Betätigungselement, in der Zeit der Abkopplung vom Verschlusselement eine Vorlauf-Geschwindigkeit aufbauen kann, also bereits beschleunigt wird, bevor es mit dem Verschlusselement am Anschlagort in Kontakt tritt. Diese Vorlauf-Geschwindigkeit kann dann gezielt dafür benutzt werden, einen Impuls aufzubauen, der dann auf das Verschlusselement übertragen wird. Hieraus ergibt sich letztendlich eine höhere Endgeschwindigkeit des Verschlusselements in Verschlussrichtung als wenn das Betätigungselement und das Verschlusselement zusammen und in Kontakt am Anschlagort denselben Weg durchlaufen würden, den das Verschlusselement hier nach der Impulsübertragung durchläuft. Dies hat den Effekt, dass das Verschlusselement schneller und effektiver seine Verschlusswirkung entfaltet und somit der gewünschte sehr zielgenaue und zügige Tropfenabriss erzielt wird. Hierdurch sind auch geringere Tropfengrößen möglich.

Während im Stand der Technik also eine ständige Kopplung des Betätigungselements des Aktorsystems mit dem Verschlusselement in Verschlussrichtung vorgesehen ist, wendet sich die vorliegende Erfindung von diesem permanent verbundenen System explizit ab und ersetzt es durch eine nur temporäre Verbindung und mechanische Entkopplung von Betätigungs- und Verschlusselement. Die beiden Elemente können daher zeitweise eigenständige Bewegungsabläufe durchführen, die dann bei ihrer Zusammenführung zum richtigen Zeitpunkt dazu führen, dass die Geschwindigkeit des Verschlusselements in Verschlussrichtung größer sind obwohl der zurückzuliegende Weg des Verschlusselements in Richtung seiner Endposition, also der Verschlussposition, erheblich kürzer ist. Ein Verfahren der eingangs genannten Art wird erfindungsgemäß dadurch weitergebildet, dass es mit Hilfe eines Dosiersystems durchgeführt wird, das ein Aktorsystem umfasst, das mindestens ein Betätigungselement umfasst, und eine Düse mit einer Austrittsöffnung. Dabei wird das Betätigungselement in einer Verschlussrichtung zuerst in einer ersten Teilbewegung so bewegt, dass es von dem Verschlusselement an einem bestimmungsgemäßen Anschlagort getrennt ist, dann auf das Verschlusselement am Anschlagort auftrifft und einen Impuls auf das Verschlusselement ausübt.

Weitere besonders vorteilhafte Ausgestaltungen und Weiterbildungen der Erfindung ergeben sich auch aus den abhängigen Ansprüchen sowie der nachfolgenden Beschreibung. Dabei kann das Verfahren auch entsprechend den abhängigen Ansprüchen zum Dosiersystem und gemäß den Ausführungen in der folgenden Beschreibung weitergebildet sein und umgekehrt.

Im Rahmen der Erfindung ist es bevorzugt, das Aktorsystem und das Verschlusselement jeweils so auszubilden, anzuordnen und zu begrenzen, dass das Betätigungselement und das Verschlusselement im Betrieb entlang einer Achse der Verschlussrichtung einen unterschiedlichen maximalen Weg durchlaufen. Das Betätigungselement und das Verschlusselement haben also einen unterschiedlichen, begrenzten, Hub. Besonders bevorzugt wird im Rahmen dessen, dass ein maximaler Weg des Verschlusselements kleiner ist als ein maximaler Weg des Betätigungselements. Allgemein gilt dabei, dass je größer der Unterschied zwischen dem Hub des Betätigungselements und dem Hub des Verschlusselements ist, desto größer der Impuls der beim Auftreffen des Betätigungselements auf das Verschlusselement während der Verschlussbewegung in Verschlussrichtung wird. Je höher wiederum der Impuls bei diesem Auftreffen ist, desto schneller wird das Verschlusselement in Richtung seiner bestimmungsgemäßen Endposition befördert.

Auf seinem Weg alleine bis zum Erreichen des Verschlusselements am Anschlagort entwickelt das Betätigungselement eine kinetische Energie, die dann beim Auftreffen auf das Verschlusselement wirkt. Hierdurch entsteht ein Impuls und letztlich eine deutlich stärkere Beschleunigung des Verschlusselements, als wenn das Betätigungselement den gesamten Weg gemeinsam mit dem Verschlusselement des Betätigungselements durchlaufen hätte.

Es hat sich in Versuchen gezeigt, dass der Hub, das heißt der maximale Weg, des Betätigungselements, bevorzugt mindestens 1,1-mal, besonders bevorzugt mindestens doppelt, so groß ist wie der Hub des Verschlusselements.

Die Schließgeschwindigkeit des Verschlusselements beträgt im Betrieb vorzugsweise mehr als 0,5 m/s.

Bei einem Versuchsaufbau wies das Verschlusselement eine Masse von 1g (inklusive Federung) auf und das Betätigungselement eine Masse von 3,5 g (typische Werte rangieren von 3,5 bis 10 g), und es wirkte eine (konstant angenommene) Antriebskraft von 250 N auf das Betätigungselement. Der Gesamthub des Betätigungselements lag bei 0,3 mm, der Gesamthub des Verschlusselements in einem ersten Szenario bei 0,09 mm und bei einem zweiten Szenario bei 0,15 mm, also der Hälfte des Gesamthubs.

### Hieraus ergaben sich folgende Werte:

Das Betätigungselement entwickelte im ersten Szenario eine Geschwindigkeit von 5,5 m/s, beim zweiten Szenario von 4,6 m/s. Das Verschlusselement wurde im ersten Szenario auf eine Geschwindigkeit von 7,7 m/s (beim Auftreffen auf die Austrittsöffnung) beschleunigt, im zweiten Szenario auf 6,4 m/s. Diese Werte berücksichtigen bereits die Wirkverluste bei der Impulsübertragung, sie wären sonst nochmals um 20% höher ausgefallen. Wären die beiden den jeweiligen Hub des Verschlusselements gemeinsam verfahren worden, so hätte sich im ersten Szenario eine gemeinsame Geschwindigkeit von 3,1 m/s und im zweiten Szenario von 4 m/s ergeben. Der reduzierte Hub des Verschlusselements (und damit seine geringe Fähigkeit, über die kurze Strecke Geschwindigkeit zu entwickeln) wird also durch die Impulsübertragung vom Betätigungselement ausgeglichen, so dass sich ein ruckartiger, sehr schneller Stoß ergibt. Es kann zusammenfassend konstatiert werden, dass bei einem doppelten Hub des Betätigungselements im Vergleich zu dem des Verschlusselements eine sehr gut erhöhte Geschwindigkeit des Verschlusselements erzielt werden kann.

Ein solch unterschiedlicher Hub des Betätigungselements und des Verschlusselements kann beispielsweise dadurch realisiert werden, dass das Verschlusselement durch eine Anschlagvorrichtung in seinem maximalen Weg entlang einer Achse der Verschlussrichtung limitiert ist. Eine solche Anschlagvorrichtung kann beispielsweise innerhalb eines Gehäuses des Dosiersystems als fest installierte Anschlagfläche oder allgemein als fest installierter Anschlagort realisiert sein. Sie kann jedoch auch, und dies ist bevorzugt, eine in ihrer Position verstellbare Anschlagvorrichtung sein, beispielsweise eine Anschlagschraube, die in das Gehäuse in Richtung des Verschlusselements bzw. weg vom Verschlusselement eingedreht bzw. herausgedreht werden kann.

Eine Weiterbildung einer solchen verstellbaren Anschlagvorrichtung besteht beispielsweise darin, dass es sich dabei um eine automatisch, bevorzugt motorisch, verstellbare Anschlagvorrichtung handelt. Eine motorische Anschlagvorrichtung kann beispielsweise über einen Stellmotor verstellt werden. Andere automatische Anschlagvorrichtungen umfassen mechanisch, beispielsweise hydraulisch oder pneumatisch, betriebene, bevorzugt von außerhalb des Dosiersystems betätigbare feststellbare Anschlagvorrichtungen.

Bei einer automatisch verstellbaren Anschlagvorrichtung kann weiterhin mittels entsprechender Messgeräte eine Position der Anschlagvorrichtung bzw. ein Kräfteverhältnis innerhalb des Dosiersystems, insbesondere was die Kräfte des Verschlusselements auf die Anschlagvorrichtung angeht, ermittelt werden. Die hieraus generierten Daten, ob Positionsdaten oder auftretende Kräfte repräsentierende Messdaten, können dann als Basis einer Verstellung der Position der Anschlagvorrichtung verwendet werden. Vorteilhafterweise kann dies innerhalb eines geschlossenen Regelkreislaufs erfolgen, so dass bei zu hohen Kräften des Verschlusselements auf die Anschlagvorrichtung beispielsweise so nachgeregelt werden kann, dass die Anschlagvorrichtung in ihrer Position vom Verschlusselement weiter beabstandet wird.

Das Aktorsystem kann elektrisch beziehungsweise elektronisch betrieben werden. Erfindungsgemäß umfasst das Aktorsystem einen piezoelektrischen Aktor. Elektrische, insbesondere aber elektronische Aktoren und ganz besonders piezoelektrische Aktoren sind sehr schnell und effektiv in ihrer Wirkung und können daher insbesondere bei Mikrodosiersystemen und bei den hier geforderten hochfeinen Dosierungsauflösungen besonders effektiv eingesetzt werden.

Erfindungsgemäß umfasst das Betätigungselement einen Hebel, der einen Aktor mit dem Verschlusselement temporär verbindet. Ein derartiger Hebel hat neben der Kraftübertragung vom Aktor auf das Verschlusselement den Zusatzvorteil, dass er eine Übersetzungswirkung entfalten kann, so dass beispielsweise ein geringerer Hub des Aktors genügt, um durch eine entsprechende Übersetzung über den Hebel einen größeren Hub im Bereich des Verschlusselements, das heißt entlang der Wirkungsachse des Verschlusselements, zu entfalten.

Ganz allgemein ist es bevorzugt, dass ein maximaler Arbeitsweg eines Aktors des Aktorsystems von einem maximalen Weg des Verschlusselements abweicht und dabei besonders bevorzugt größer ist als der des Verschlusselements. Dies bedeutet, dass auch, wenn der Aktor nicht direkt auf das Verschlusselement wirkt, sein Hub größer ist als der des Verschlusselements. Hierdurch kann auch ein größerer Hub des Betätigungselements erreicht werden.

Es hat sich außerdem als vorteilhaft erwiesen, wenn auch ein maximaler Arbeitsweg eines Aktors des Aktorsystems und/oder ein maximaler Weg des Betätigungselements durch eine Anschlagvorrichtung limitiert ist. Hierbei ist der Begriff der Anschlagvorrichtung sehr breit zu fassen: Eine Anschlagvorrichtung kann hier (wie bereits beschrieben) ein mechanisches Element darstellen, an das der Aktor des Aktorsystems bzw. das Betätigungselement in einer bestimmten Position anstößt. Eine Anschlagvorrichtung kann jedoch auch durch entsprechende Programmierung beziehungsweise Voreinstellung einer Steuerung des Aktors realisiert sein, das heißt beispielsweise softwaremäßig realisiert sein. Hier genügt es also, eine elektronische Hubsteuerung im Sinne einer Hublimitierung einzusetzen. Insgesamt ist durch die Limitierung des Hubs des Aktors des Aktorsystems bzw. des Betätigungselements gewährleistet, dass die Hübe des Aktors und des Verschlusselements zueinander definiert einstellbar sind und somit auch die zwischen dem Betätigungselement und dem Verschlusselement auftretenden Kräfte im Vorhinein abschätzbar und definierbar sind.

Zusätzlich zu dem Aktorsystem, das das Betätigungslement und im Endeffekt auch das Verschlusselement in mindestens die Verschlussrichtung bewegt, kann vorgesehen sein, dass das Verschlusselement und/oder das Aktorsystem federbasiert in eine Öffnungsrichtung und/oder in die Verschlussrichtung gedrückt ist. Eine solche federbasierte Kraftauswirkung auf das Betätigungselement bzw. das Verschlusselement kann beispielsweise bei einer Wirkung in Öffnungsrichtung bewirken, dass das Verschlusselement und/oder das Betätigungselement wieder in eine Öffnungsposition zurück gedrückt werden, so dass für diese Bewegung kein eigener selbsttätiger Aktor notwendig ist. Hierdurch wird das Dosiersystem vereinfacht und effektiver gestaltet.

Um eine Anschlagvorrichtung jederzeit so positioniert zu halten, dass sie ihre den Hub des Aktorsystems bzw. des Verschlusselements limitierende Wirkung entfaltet, ist bevorzugt vorgesehen, dass sie in ihrer Position einstellbar ist und dies besonders bevorzugt federvorgespannt. Die Anschlagvorrichtung ist also nicht fest installiert, sondern ihre Position kann variiert und dann fixiert werden. Als einfache Maßnahmen hierfür hat sich eine federvorgespannte Fixierung erwiesen.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Es zeigen:
- Figur 1: eine Frontansicht eines Dosiersystems gemäß dem Stand der Technik,
- Figur 2: eine Schnittansicht desselben Dosiersystems wie in Figur 1 entlang einer Schnittlinie A - A in einem ersten Betriebszustand,
- Figur 3: dieselbe Schnittansicht desselben Dosiersystems wie in Figur 2 in einem zweiten Betriebszustand,
- Figur 4: dieselbe Schnittansicht desselben Dosiersystems wie in den vorhergehenden Figuren mit einer veränderten Grundeinstellung,
- Figur 5: eine perspektivische Ansicht eines Dosiersystems,
- Figur 6: eine Frontansicht desselben Dosiersystems wie in Figur 5,
- Figur 7: eine Schnittansicht desselben Dosiersystems wie in den Figuren 5 und 6 entlang einer Schnittlinie A - A aus Figur 6, wobei das Dosiersystem in einem ersten Betriebszustand dargestellt ist,
- Figur 8: dieselbe Schnittansicht desselben Dosiersystems wie in Figur 7 in einem zweiten Betriebszustand,
- Figur 9: dieselbe Schnittansicht desselben Dosiersystems wie in den Figuren 7 und 8 in einem dritten Betriebszustand,
- Figur 10: eine Frontansicht einer Ausführungsform eines erfindungsgemäßen Dosiersystems,
- Figur 11: eine Schnittansicht des Dosiersystems wie in Figur 10 entlang einer Schnittlinie A - A.

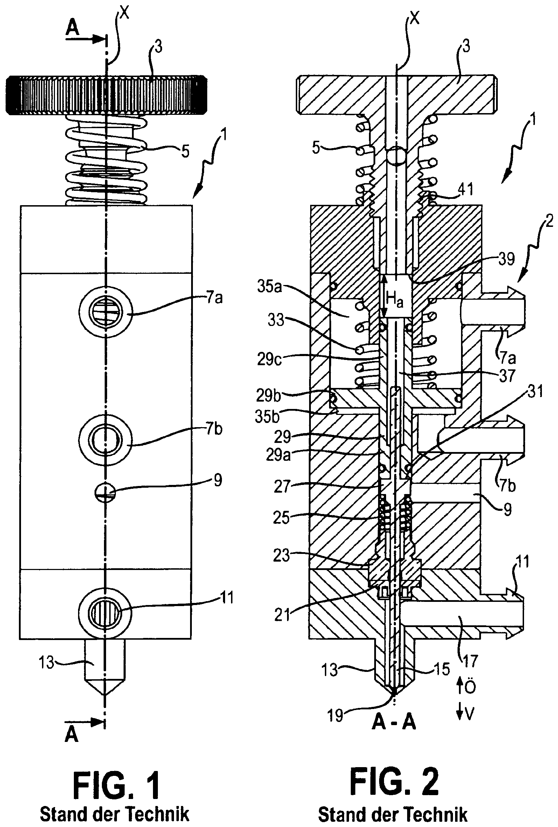

Figuren 1 und 2 zeigen ein Dosiersystem 1 gemäß dem Stand der Technik. Es umfasst ein Aktorsystem 2 und eine Düse 13, wobei ein Verschlusselement 15 in Form eines Stößels 15 durch das Aktorsystem 2 in Verschlussrichtung V der Düse 13, das heißt insbesondere in Richtung einer Austrittsöffnung 19 der Düse 13, bzw. in einer Öffnungsrichtung Ö von dieser Austrittsöffnung 19 weg bewegt werden kann. Diese Verschluss- und Öffnungsbewegung erfolgt entlang einer Wirkachse X, die zentral innerhalb des Dosiersystems 1 angeordnet ist und die durch die Ausrichtung des Stößels 15 innerhalb des Dosiersystems 1 definiert ist.

Das Aktorsystem 2 ist bei dieser Ausführungsform als pneumatisches bzw. hydraulisches System realisiert. Dies bedeutet, dass ein als Betätigungselement 29 wirkender Aktor 29 des Aktorsystems 2 durch Druckgas bzw. durch Druckflüssigkeit in einem Zylinder hin und her bewegt werden kann, in dem sich eine obere Kammer 35a und eine untere Kammer 35b befinden, die durch den als Kolben 29 realisierten Aktor 29 voneinander getrennt sind. Die obere Kammer 35a und die untere Kammer 35b werden jeweils über einen ersten pneumatischen Einlass 7a und einen zweiten pneumatischen Einlass 7b mit Über-bzw. Unterdruck versorgt. Der erste pneumatische Einlass 7a führt in die obere Kammer 35a, der zweite pneumatische Einlass 7b führt in die untere Kammer 35b. Wird eine Flüssigkeit oder ein Gas durch den ersten pneumatischen Einlass 7a mit einem höheren Druck in die erste Kammer 35a geleitet als ein Druck, der über den zweiten pneumatischen Einlass 7b in der unteren Kammer 35b anliegt, so bewegt sich der Kolben 29 in Richtung der unteren Kammer 35b. Bei einem entgegengesetzten Druckverhältnis bewegt sich der Kolben 29 in Richtung der oberen Kammer 35a. Die Bewegung des Kolbens 29 nach unten in Richtung der Austrittsöffnung 19 wird zusätzlich noch unterstützt durch eine Aktorfeder 33, die in der oberen Kammer 35b angeordnet ist, so dass sie den Kolben 29 nach unten drückt.

Der Kolben 29 ist einstückig ausgebildet und weist drei Bereiche auf, nämlich einen unteren Aktorbereich 29a, einen mittleren Aktorbereich 29b und einen oberen Aktorbereich 29c. Der mittlere Aktorbereich 29b ist derjenige Bereich des Kolbens 29, der die obere Kammer 35a von der unteren Kammer 35b trennt, während der untere Aktorbereich 29a und der obere Aktorbereich 29c innerhalb des Gehäuses des Dosiersystems 1 innerhalb zylindrischer Hohlräume geführt werden. Dabei ist der untere Aktorbereich 29a mit dem Stößel 15 wirkverbunden. Dies erfolgt durch eine formschlüssige und eine kraftschlüssige Verbindung, die unter anderem daraus besteht, dass der Stößel 15 entlang eines Anschlagorts 31, nämlich entlang einer Anschlagfläche 31 direkt an der Unterseite des unteren Aktorbereichs 29, aufliegt. Hierzu weist der Stößel 15 einen Erweiterungsbereich 27 auf, dessen Querschnitt senkrecht zur Verschlussrichtung V größer ist als die Bereiche des Stößels 15, die oberhalb und unterhalb des Erweiterungsbereichs 27 liegen. Der oberhalb des Erweiterungsbereichs 27 liegende Teil des Stößels 15 ragt in einen Hohlraum 37 innerhalb des Kolbens 29 hinein, so dass der Formschluss zwischen dem Stößel 15 und dem Kolben 29 noch weiter geführt wird als nur im Bereich des Anschlagorts 31. Der Stößel 15 wird somit oberseitig innerhalb des Kolbens 29 gehalten. Er wird außerdem an der dem Kolben 29 abgewandten Seite des Erweiterungsbereichs 27 durch eine Ausrichtungsvorrichtung 23 in einer axialen Ausrichtung entlang der Wirkachse X gehalten. Über eine umlaufende Dichtung 21 führt er in den Bereich eines Dosierstoffkanals 17, der von einer Zuleitung 11 in Richtung der Austrittsöffnung 19 der Düse 13 führt.

Die form- bzw. kraftschlüssige Verbindung zwischen dem Stößel 15 und dem Kolben 29 entlang der Anschlagfläche 31 wird durch eine Verschlusselementfeder 25 gewährleistet, die von der Ausrichtungsvorrichtung 23 ausgehend bis zum Erweiterungsbereich 27 des Stößels 15 reicht und diesen im Betrieb immer in Kontakt mit dem Kolben 29 hält. Eine Entlüftungsöffnung 9 dient dazu, bei Bewegungen des Stößels 15 Über- bzw. Unterdrücke auszugleichen.

Dass Dosiersystem 1 weist weiterhin eine Anschlagvorrichtung 3 in Form einer Anschlagschraube 3 auf, die über ein Gewinde 41 in Richtung des Inneren des Gehäuses des Dosiersystems 1 eingefahren werden kann und dadurch den Hub Hₐ des Kolbens 29 limitiert. Die Anschlagschraube 3 ist mittels einer Anschlagfeder 5 in ihrer jeweiligen Position gehalten und kann nur gezielt durch Drehung weiter in das Innere des Gehäuses des Dosiersystems 1 bzw. weiter aus dem Inneren des Gehäuses heraus bewegt werden. Der Kolben 29 kann dadurch nur bis zu einem Aktor-Auftreffort 39 der Anschlagschraube 3 an ihrem dem Kolben 29 zugewandten Ende bewegt werden.

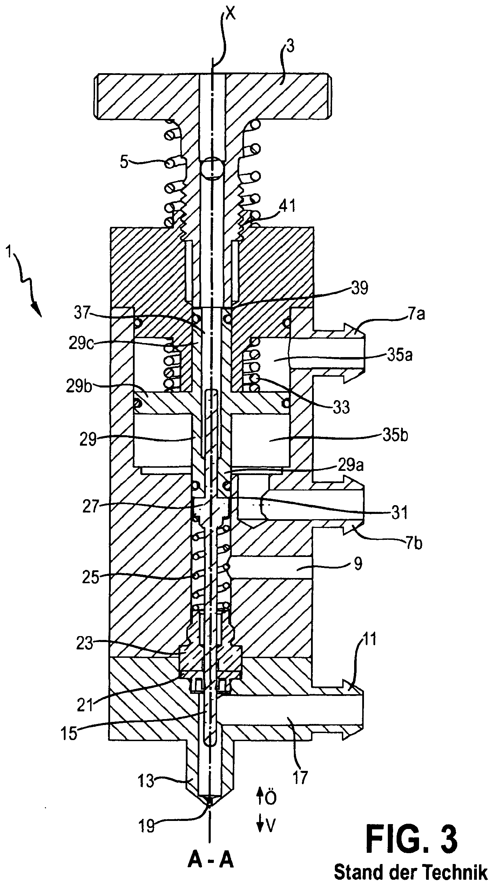

Figur 3 zeigt dieselbe Dosiervorrichtung 1 in einem zweiten Betriebszustand, nämlich in einem Zustand, in dem der Kolben 29 maximal bis zum Aktor-Auftreffort 39 nach oben gefahren ist. Dabei wurde die Position der Anschlagschraube 3 nicht verändert, so dass der Aktor-Auftreffort 39 den Hub des Kolbens 29 nur geringfügig limitierte. Es ist zu erkennen, dass auch in dieser oberen Position des Kolbens 29 die form- bzw. kraftschlüssige Verbindung zwischen dem Kolben 29 und dem Stößel 15 aufgrund der Federspannung der Verschlusselementfeder 25 aufrechterhalten bleibt und die beiden entlang des Anschlagorts 31 miteinander in permanenter Verbindung stehen.

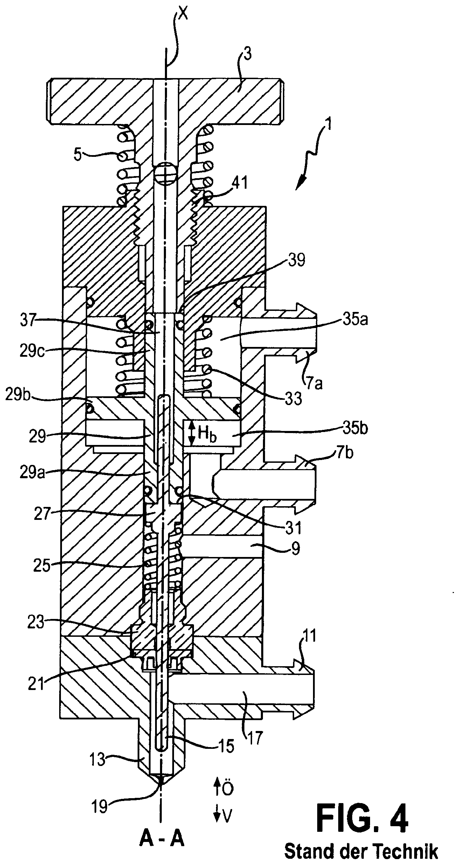

Figur 4 zeigt dasselbe Dosiersystem 1 mit einer veränderten Grundeinstellung. Hier ist nämlich die Anschlagschraube 3 weiter in Innenrichtung des Gehäuses des Dosiersystems 1, d.h. in Verschlussrichtung V, gedreht, so dass der Aktor-Auftreffort 39 weiter unten im Bild positioniert ist. Dadurch wurde automatisch der Hub H_{b} des Kolbens 29 reduziert. Im Vergleich zwischen den Figuren 3 und 4 ist erkennbar, dass auch entsprechend die Position des Stößels 15 in der obersten möglichen Stellung des Aktors 29 dadurch verändert wird: Das untere Ende des Stößels 15 bei der in Figur 4 gezeigten Grundeinstellung liegt näher an der Austrittsöffnung 19 als dies bei der in Figur 3 gezeigten Grundeinstellung der Fall ist. Dies hat den Effekt, dass der Weg des Stößels 15 in Verschlussrichtung V bis hin zur Austrittsöffnung 19 der Düse 13 kürzer ist. Dies bedeutet jedoch auch, dass der Stößel 15 nur kürzer beschleunigt werden kann und daher langsamer in Richtung der Austrittsöffnung 19 gelangt. Die Verkürzung des Hubs von einem ersten Hub Hₐ (vgl. Fig. 3) zu einem zweiten Hub H_{b} (vgl. Fig. 4) hat daher negative Auswirkungen auf die Reaktionsgeschwindigkeit des Stößels.

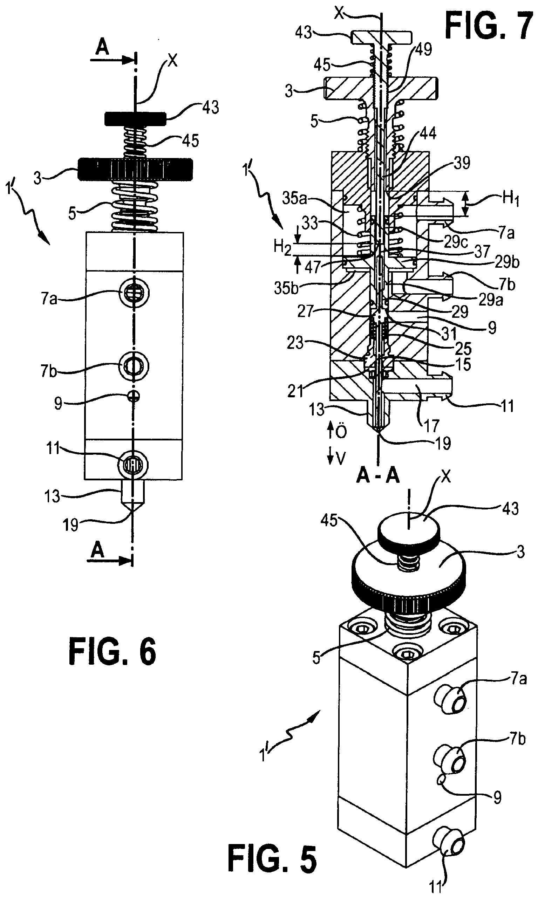

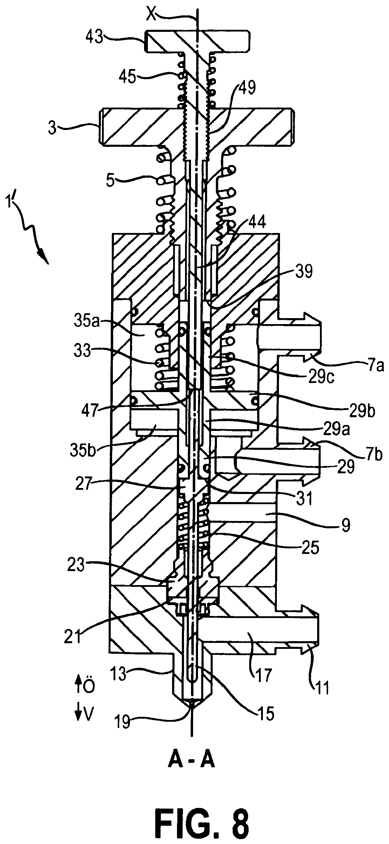

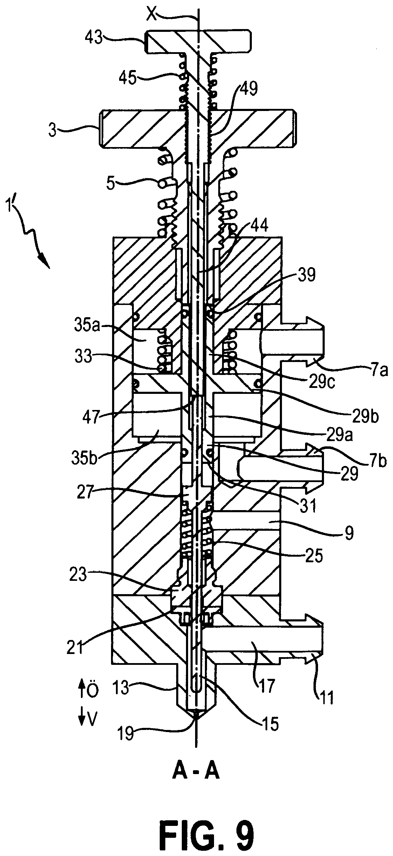

Figuren 5, 6 und 7 zeigen ein Dosiersystem 1'. Neben den bereits bekannten in den vorherigen Figuren erwähnten Elementen weist es eine Anschlagvorrichtung 43 auf, die in der bereits erwähnten Anschlagschraube 3 eingelassen ist. Die Anschlagvorrichtung 43 wird wiederum mittels eines Gewindes 49 innerhalb der Anschlagschraube 3 so gehalten, dass sie in Richtung des Inneren des Gehäuses, d.h. in Verschlussrichtung V, gefahren werden kann bzw. in der Gegenrichtung herausgeschraubt werden kann. Auch die Anschlagvorrichtung 43 ist mittels einer Anschlagfeder 45 federvorgespannt gehalten. Die Anschlagvorrichtung 43 ragt in einem unteren Bereich über den Aktor-Auftreffort 39 hinaus und ist innerhalb eines Hohlraums des Kolbens 29 im oberen Aktorbereich 29c positioniert. An ihrer unteren, dem Stößel 15 zugewandten Seite weist die Anschlagvorrichtung einen Stößel-Auftreffort 47 auf. Der Weg des Stößels 15 von der Austrittsöffnung 19 der Düse 13 bis zum Stößel-Auftreffort 47 ist daher ein limitierter Hub H₂, der im Vergleich zu den limitierten Hub H₁ des Kolbens 29 geringer ausfällt. Der Effekt dieses verkürzten maximalen Wegs H₂ wird anhand der Figuren 8 und 9 deutlich gemacht:
Figur 8 zeigt dieselbe Dosiervorrichtung 1', wobei der Stößel 15 nunmehr bis an eine durch den Stößel-Auftreffort 47 definierte Position geführt wurde, was auf Basis der Federkraft der Verschlusselementfeder 25 erfolgte. Es ist auch zu erkennen, dass der Kolben 29 bis zu seinem Aktor-Auftreffort 39 noch eine weitere Strecke zurücklegen kann. In dieser Position werden also der Stößel 15 und der Kolben 29 entlang des Anschlagorts 31, entlang dem sie bisher miteinander form- bzw. kraftschlüssig verbunden waren, voneinander getrennt, d.h. entkoppelt. Diesen Effekt kann man insbesondere in Figur 9 sehen, wo nun auch der Kolben 29 am Aktor-Auftreffort 39 angelangt ist und bereits vom Stößel 15 am Anschlagort 31 getrennt ist.

Wird nun die anhand der Figuren 7, 8 und 9 gezeigte Aufwärtsbewegung in Öffnungsrichtung in die entgegengesetzte Richtung, nämlich in die Verschlussrichtung V, durchgeführt, so vollführt zunächst der Kolben 29 alleine eine Abwärtsbewegung in Verschlussrichtung V, trifft dann in der in Figur 8 gezeigten Position wiederum am Anschlagort 31 auf den Stößel 15 und bewirkt dadurch einen Impuls I auf den Stößel 15. Dieser bewegt sich dann schneller als der Kolben weiter bis hin zur Position, die in Figur 7 gezeigt ist. Der Kolben 29 vollführt also zuerst eine erste Teilbewegung alleine, trifft dann am Anschlagort 31 auf den Stößel 15 und bewegt sich dann in einer zweiten Teilbewegung wieder separat vom Stößel 15 in Richtung der Austrittsöffnung 19. Ist der Stößel an der Austrittsöffnung 19 angelangt, so treffen sich der Kolben 29 und der Stößel kurz darauf wieder am Anschlagort 31. Hier nun entsteht der Effekt, der der Erfindung eine neue Qualität verleiht: auf seinem Weg während der ersten Teilbewegung von seiner obersten Position bis zu der Position, die in Figur 8 gezeigt ist, entwickelt der Kolben 29 alleine eine Geschwindigkeit, so dass er einen Impuls I auf den Stößel 15 beim Auftreffen am Anschlagort 31 ausüben kann. Diese vorherige Beschleunigung des Kolbens 29 ohne Stößel 15 führt dazu, dass der Stößel 15 nun eine höhere Geschwindigkeit als der Kolben 29 erreichen kann. Hierdurch wird die Verschlussbewegung des Stößels 15 schneller - er kann die Austrittsöffnung 19 in seiner Endposition des Stößels 15 schneller erreichen.

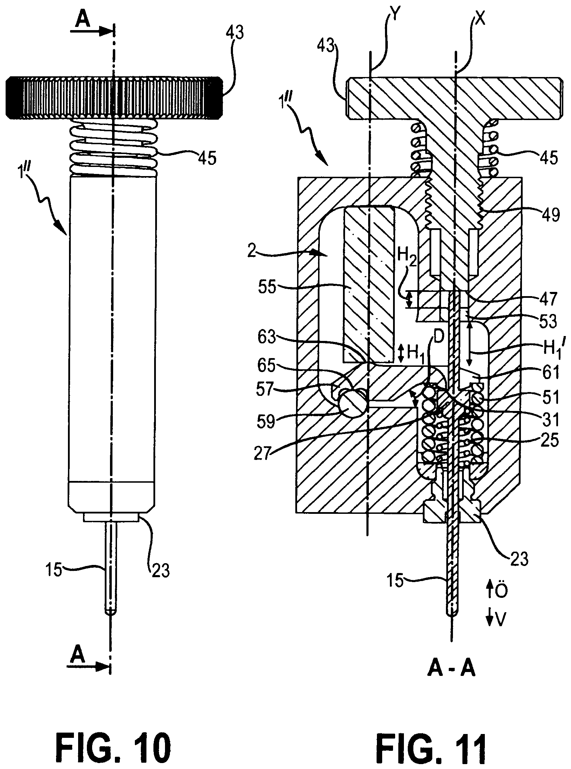

Figuren 10 und 11 zeigen eine Ausführungsform eines erfindungsgemäßen Dosiersystems 1". Hier ist das Aktorsystem 2 nicht als pneumatisches bzw. hydraulisches Aktorsystem 2 ausgebildet, sondern es umfasst einen piezoelektrischen Aktor 55, dessen Bewegungen über einen Hebel 57 auf einen Stößel 15 übertragen werden. Der Bereich der Düse ist im vorliegenden Ausführungsbeispiel nicht gezeigt, er kann jedoch analog ausgebildet sein zu dem in den Figuren 1 bis 9 gezeigten Ausführungsbeispiel. Der Hebel 57 ist an drei Stellen gelagert: An einem Anschlagort 31 ist er temporär mit einem Erweiterungsbereich 27 des Stößels 15 verbunden, der analog zu den in den vorherigen Figuren gezeigten Formen ausgebildet ist. Hierzu umfängt ein Endbereich 61 des Hebels den oberen Teil des Stößels 15. Dieser Endbereich ist daher in seinem Querschnitt senkrecht zur Verschlussrichtung V u-förmig bzw. gabelförmig ausgebildet. Oberseitig weist der Hebel 57 in Richtung des piezoelektrischen Aktors 55 eine kleine Ausbuchtung auf, die an einem ersten Auflagebereich 63 endet, wo er mit dem piezoelektrischen Aktor 55 mittels einer Linienauflage verbunden ist. Weiterhin ist der Hebel 57 an seiner dem piezoelektrischen Aktor 55 abgewandten Unterseite über eine zweite Linienauflage in einem zweiten Auflagebereich 65 auf einem Zylinderstift 59 gelagert. Um die Reibung zwischen dem Hebel 57 und dem Zylinderstift 59 zu verringern, weist der Hebel 57 im zweiten Auflagebereich 65 zwei Aussparungen auf. In Öffnungsrichtung Ö werden sowohl der Stößel 15 über eine Verschlusselementfeder 25 als auch der Hebel 57 über eine Aktorfeder 51 gedrückt.

Wird der piezoelektrische Aktor 55 zur Bewegung angeregt, so wird diese über den ersten Auflagebereich 63 in eine Drehbewegung D umgewandelt. Hierdurch wird der Stößel 15 mithilfe des Kontakts am Anschlagort 31 entlang der Wirkachse X in Verschlussrichtung verschoben. Der Hub H₁ des piezoelektrischen Aktors 55 ist nicht zwangsläufig gleich dem Hub H₁', den der Hebel 57 als Betätigungselement 57 entlang der Wirkachse X aufweist. Vielmehr kann durch eine entsprechende Übersetzung auch ein höherer Hub H₁' entlang der Achse X durchgeführt werden. Es besteht also ein erster Hub H₁ entlang einer Aktorachse Y des piezoelektrischen Aktors 55 und ein zweiter Hub H₁' entlang der Wirkachse X des Stößels 15.

Der Stößel 15 wird an seiner Oberseite wiederum von einer Anschlagvorrichtung 43 an einem Stößel-Auftreffort 47 gestoppt. Er weist daher einen Hub H₂ auf, der wiederum geringer ist als der Hub H₁' des Hebels 57 entlang der Wirkachse X. Sobald bei einer Bewegung in Öffnungsrichtung die hier dargestellte Stellung erreicht ist, bewegt sich der Hebel 57 weg vom Anschlagort 31 und trennt sich vom Stößel 15; der Hebel 57 geht alleine weiter nach oben. In anderer Richtung vollführt der Hebel 57 wiederum zunächst eine alleinige Bewegung in Richtung des Stößels 15, trifft dann am Anschlagort 31 auf diesen auf und bewegt ihn dann mit einem Impuls weiter in Richtung einer Austrittsöffnung einer Düse. Dieses Prinzip entspricht also im Wesentlichen dem Ablaufprinzip, das bereits anhand der Figuren 5 bis 9 erläutert wurde.

Während das Dosiersystem, das anhand der Figuren 5 bis 9 dargestellt wurde, ein pneumatisches bzw. hydraulisches System zeigte, das komplett entlang einer Wirkachse X ausgerichtet war, ist in den Figuren 10 und 11 ein erfindungsgemäßes piezoelektrisches Aktorsystem gezeigt worden, das eine von der Wirkachse X unterschiedliche Aktorachse Y aufweist.

Es wird abschließend noch einmal darauf hingewiesen, dass es sich bei den vorhergehend detailliert beschriebenen Komponenten des Dosiersystems bzw. der Düse und des Aktorsystems lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Außerdem können "Einheiten" aus einer oder mehreren, auch räumlich verteilt angeordneten, Komponenten bestehen.

### Bezugszeichenliste:

- 1, 1', 1": Dosiersystem
- 2: Aktorsystem
- 3: Anschlagvorrichtung - Anschlagschraube
- 5: Anschlagfeder
- 7a, 7b: pneumatische Einlässe
- 9: Entlüftungsöffnung
- 11: Zuleitung
- 13: Düse
- 15: Verschlusselement - Stößel
- 17: Dosierstoffkanal
- 19: Austrittsöffnung
- 21: Dichtung
- 23: Ausrichtungsvorrichtung
- 25: Verschlusselementfeder
- 27: Erweiterungsbereich
- 29: Aktor - Kolben
- 29a: unterer Aktorbereich
- 29b: mittlerer Aktorbereich
- 29c: oberer Aktorbereich
- 31: Anschlagort - Anschlagfläche
- 33: Aktorfeder
- 35a: obere Kammer
- 35b: untere Kammer
- 37: Hohlraum
- 39: Aktor-Auftreffort
- 41: Gewinde
- 43: Anschlagvorrichtung
- 45: Anschlagfeder
- 47: Stößel-Auftreffort
- 49: Gewinde
- 51: Aktorfeder
- 55: piezoelektrischer Aktor
- 57: Hebel
- 59: Zylinderstift
- 61: Endbereich
- 63: erster Auflagebereich
- 65: zweiter Auflagebereich

- D: Drehbewegung
- Hₐ, H_{b}, H₁, H₁', H₂: Hub
- I: Impuls
- Ö: Öffnungsrichtung
- V: Verschlussrichtung
- X: Wirkachse
- Y: Aktorachse

## Patentansprüche

1. Dosiersystem (1', 1") für einen flüssigen bis zähflüssigen Dosierstoff umfassend ein Aktorsystem (2), das mindestens ein Betätigungselement (29, 55) umfasst, und eine Düse (13) mit einer Austrittsöffnung (19), wobei das Aktorsystem (2) einen piezoelektrischen Aktor (55) umfasst und das Dosiersystem so ausgebildet ist, dass das Betätigungselement (29,57) bei einer Bewegung in einer Verschlussrichtung (V) zuerst in einer ersten Teilbewegung so bewegt wird, dass das Betätigungselement (29,57) von dem Verschlusselement (15) an einem bestimmungsgemäßen Anschlagort (31) getrennt ist, und dann auf das Verschlusselement am Anschlagort (31) auftrifft und einen Impuls (I) auf das Verschlusselement (15) ausübt, **dadurch gekennzeichnet, dass** das Betätigungselement (29,57) einen Hebel (57) umfasst, der den Aktor (55) mit dem Verschlusselement (15) temporär verbindet.

2. Dosiersystem gemäß Anspruch 1, wobei das Aktorsystem (2) und das Verschlusselement (15) jeweils so ausgebildet, angeordnet und begrenzt sind, dass das Betätigungselement (29, 57) und das Verschlusselement (15) im Betrieb entlang einer Achse (X) der Verschlussrichtung (V) einen unterschiedlichen maximalen Weg (H₁, H₁', H₂) durchlaufen.

3. Dosiersystem gemäß Anspruch 2, wobei der maximale Weg (H₂) des Verschlusselements (15) kleiner ist als der maximale Weg (H₁, H₁') des Betätigungselements (29, 57).

4. Dosiersystem gemäß einem der vorhergehenden Ansprüche, wobei das Verschlusselement (15) durch eine Anschlagvorrichtung (43) in seinem maximalen Weg (H₂) entlang einer Achse (X) der Verschlussrichtung (V) limitiert ist.

5. Dosiersystem gemäß Anspruch 4 mit einer in ihrer Position verstellbare Anschlagvorrichtung (43).

6. Dosiersystem gemäß Anspruch 5 mit einer automatisch, bevorzugt motorisch, verstellbaren Anschlagvorrichtung.

7. Dosiersystem gemäß einem der vorhergehenden Ansprüche, wobei ein maximaler Arbeitsweg (H₁) eines Aktors (55) des Aktorsystems (2) von einem maximalen Weg des Verschlusselements (H₂) abweicht.

8. Dosiersystem gemäß einem der vorhergehenden Ansprüche, wobei ein maximaler Arbeitsweg (H₁, H₁') eines Aktors (29) und/oder ein maximaler Weg (H₁) des Betätigungselements des Aktorsystems (2) durch eine Anschlagvorrichtung (3) limitiert ist.

9. Dosiersystem gemäß einem der vorhergehenden Ansprüche, wobei das Verschlusselement (15) und/oder das Aktorsystem (2) federbasiert in eine Öffnungsrichtung (Ö) und/oder in die Verschlussrichtung (V) gedrückt ist.

10. Dosiersystem gemäß einem der vorhergehenden Ansprüche, umfassend mindestens eine, bevorzugt federvorgespannt, in ihrer Position einstellbare Anschlagvorrichtung (3, 43).

11. Verfahren zum Dosieren eines flüssigen bis zähflüssigen Dosierstoffs mit Hilfe eines Dosiersystems (1', 1"), umfassend ein Aktorsystem (2), wobei das Aktorsystem (2) einen piezoelektrischen Aktor (55) umfasst und das Dosiersystem mindestens ein Betätigungselement (29, 57) umfasst, und eine Düse (13) mit einer Austrittsöffnung (19), wobei das Betätigungselement (29, 55) in einer Verschlussrichtung (V) zuerst in einer ersten Teilbewegung so bewegt wird, dass das Betätigungselement (29,57) von dem Verschlusselement (15) an einem bestimmungsgemäßen Anschlagort (31) getrennt ist, dann auf das Verschlusselement am Anschlagort (31) auftrifft und einen Impuls (I) auf das Verschlusselement (15) ausübt, **dadurch gekennzeichnet, dass** das Betätigungselement (29,57) einen Hebel (57) umfasst, der den Aktor (55) mit dem Verschlusselement (15) temporär verbindet.

## Claims

1. Dosing system (1', 1") for a liquid to viscous dosing material comprising an actuator system (2), that has at least one actuating element (29, 55) and a nozzle (13) with an outlet opening (19), wherein the actuator system has a piezoelectric actuator and the dosing system is realized so that, during a movement in closure direction (V), the actuating element (29, 57) is initially moved in a first partial movement such that the actuating element (29, 57) is separated from the closure element (15) at an intended stop location (31), and subsequently strikes the closure element at the stop location (31) and exerts an impulse (I) on the closure element (15), **characterized in that** the actuating element (29, 55) comprises a lever (57) which temporarily connects an actuator (55) with the closure element (15).

2. Dosing system according to claim 1, whereby the actuator system (2) and the closure element (15) are each realized, arranged and constrained in such a way that in operation the actuating element (29, 57) and the closure element (15) travel different maximum paths (H₁, H₁', H₂) along an axis (X) of the closure direction (V).

3. Dosing system according to claim 2, whereby the maximum path (H₂) of the closure element (15) is shorter than the maximum path (H₁, H₁') of the actuating element (29, 57).

4. Dosing system according to any one of the preceding claims, whereby the closure element (15) is constrained by a limit stop arrangement (43) in its maximum path (H₂) along an axis (X) in the closure direction (V).

5. Dosing system according to claim 4 with a limit stop arrangement (43), the position of which can be adjusted.

6. Dosing system according to claim 5 with an automatic, preferably motorised, adjustable limit stop device.

7. Dosing system according to any one of the preceding claims, whereby a maximum travel (H₁) of an actuator (55) of the actuator system (2) differs from a maximum path (H₂) of the closure element (15).

8. Dosing system according to any one of the preceding claims, whereby a maximum travel (H₁, H₁') of an actuator (29) and/or a maximum path (H₁) of the actuating element of the actuator system (2) is constrained by a limit stop device (3).

9. Dosing system according to any one of the preceding claims, whereby the closure element (15) and/or the actuator system (2) is pressed by a spring in an opening direction (Ö) and/or in the closure direction (V).

10. Dosing system according to any one of the preceding claims, comprising at least one limit stop device (3, 43), preferably spring-loaded, the position of which can be adjusted.

11. Method of dosing a liquid to viscous dosing material with the aid of a dosing system (1', 1"), comprising an actuator system (2), wherein the actuator system has a piezoelectric actuator and the dosing system comprises at least one actuating element (29, 57) and a nozzle (13) with an outlet opening (19), whereby the dosing system is designed so that during a movement in closure direction (V) the actuating element (29, 55) is initially moved in a first partial movement such that the actuating element (29, 57) is separated from the closure element (15) at an intended stop location (31)and then strikes the closure element at the stop location (31) and exerts an impulse (I) on the closure element (15)), **characterized in that** the actuating element (29, 55) comprises a lever (57) which temporarily connects an actuator (55) with the closure element (15).

## Revendications

1. Système de dosage (1', 1") pour une substance de dosage liquide à visqueuse, comprenant un système d'actionneurs (2) qui comprend au moins un élément d'actionnement (29, 55), et une buse (13) avec une ouverture de sortie (19), dans lequel le système d'actionneurs (2) comprend un actionneur piézoélectrique et le système de dosage est réalisé de manière à ce que l'élément d'actionnement (29, 57) soit tout d'abord mû d'un premier mouvement partiel lors d'un mouvement dans une direction de fermeture (V) de manière à ce que l'élément d'actionnement (29, 57) soit séparé de l'élément de fermeture (15) au niveau d'un emplacement de butée (31) conforme et percute ensuite l'élément de fermeture au niveau de l'emplacement de butée (31) et confère une quantité de mouvement (I) à l'élément de fermeture (15), **caractérisé en ce que** l'élément d'actionnement (29, 55) qui comprend un levier (57) qui relie temporairement un actionneur (55) à l'élément de fermeture (15).

2. Système de dosage selon la revendication 1, dans lequel le système d'actionneurs (2) et l'élément de fermeture (15) sont respectivement réalisés, disposés et limités de manière à ce que l'élément d'actionnement (29, 57) et l'élément de fermeture (15) parcourent, lors du fonctionnement, une course maximale (H₁, H₁', H₂) différente le long d'un axe (X) de la direction de fermeture (V).

3. Système de dosage selon la revendication 2, dans lequel la course maximale (H₂) de l'élément de fermeture (15) est plus courte que la course maximale (H₁, H₁') de l'élément d'actionnement (29, 57).

4. Système de dosage selon l'une des revendications précédentes, dans lequel l'élément de fermeture (15) est limité par un dispositif de butée (43) concernant sa course maximale (H₂) le long d'un axe (X) de la direction de fermeture (V).

5. Système de dosage selon la revendication 4 avec un dispositif de butée (43) réglable concernant sa position.

6. Système de dosage selon la revendication 5 avec un dispositif de butée réglable automatiquement, de préférence de manière motorisée.

7. Système de dosage selon l'une des revendications précédentes, dans lequel une course de travail (H₁) maximale d'un actionneur (55) du système d'actionneurs (2) dévie par rapport à une course maximale de l'élément de fermeture (H₂).

8. Système de dosage selon l'une des revendications précédentes, dans lequel une course de travail (H₁, H₁') maximale d'un actionneur (29) et/ou une course maximale (H₁) de l'élément d'actionnement du système d'actionneurs (2) est limitée par un dispositif de butée (3).

9. Système de dosage selon l'une des revendications précédentes, dans lequel l'élément de fermeture (15) et/ou le système d'actionneurs (2) est poussé, sur la base d'un ressort, dans une direction d'ouverture (Ö) et/ou dans la direction de fermeture (V).

10. Système de dosage selon l'une des revendications précédentes, comprenant au moins un dispositif de butée (3, 43) réglable concernant sa position, de préférence précontraint par un ressort.

11. Procédé pour le dosage d'une substance de dosage liquide à visqueuse à l'aide d'un système de dosage (1', 1"), comprenant un système d'actionneurs (2) dans lequel un système d'actionneurs (2) comprend un actionneur (55) piézoélectrique et le système de dosage comprend au moins un élément d'actionnement (29, 57), et une buse (13) avec une ouverture de sortie (19), dans lequel l'élément d'actionnement (29, 55) est tout d'abord mû d'un premier mouvement partiel dans une direction de fermeture (V) de manière à ce que l'élément d'actionnement (29, 57) soit séparé de l'élément de fermeture (15) au niveau d'un emplacement de butée (31) conforme, et percute ensuite l'élément de fermeture au niveau de l'emplacement de butée (31) et confère une quantité de mouvement (I) à l'élément de fermeture (15), **caractérisé en ce que** l'élément d'actionnement (29, 55) qui comprend un levier (57) qui relie temporairement un actionneur (55) à l'élément de fermeture (15).
